# EUROPEAN PATENT SPECIFICATION

(11) **EP 4 414 393 B1**
(45) Date of publication and mention of the grant of the patent: **11.11.2026**
(21) Application number: 24154677.9
(22) Date of filing: 30.01.2024
(51) Int. Cl.: C08F 222/10, B29C 64/106, B29C 64/20, B33Y 30/00, B33Y 70/00, C08F 290/06, C09D 4/00, C09D 4/06, G03F 7/033, G03F 7/00, G03F 7/027, G03F 7/004, B33Y 10/00, B29C 64/124

(54) **CURABLE COMPOSITION, CURED PRODUCT, METHOD OF PRODUCING CURED PRODUCT, AND APPARATUS FOR PRODUCING CURED PRODUCT**
HÄRTBARE ZUSAMMENSETZUNG, GEHÄRTETES PRODUKT, VERFAHREN ZUR HERSTELLUNG EINES GEHÄRTETEN PRODUKTS UND VORRICHTUNG ZUR HERSTELLUNG EINES GEHÄRTETEN PRODUKTS
COMPOSITION DURCISSABLE, PRODUIT DURCI, PROCÉDÉ DE PRODUCTION DE PRODUIT DURCI ET APPAREIL DE PRODUCTION DE PRODUIT DURCI

(30) Priority: 10.02.2023 JP 2023018832
(43) Date of publication of application: 14.08.2024
(73) Proprietor: Meidensha Corporation, Tokyo 141-6029 (JP)
(72) Inventor: SAITO, Akira, Tokyo, 143-8555 (JP); SHIMIZU, Takayuki, Tokyo, 143-8555 (JP)
(74) Representative: Marks & Clerk LLP

(56) References cited:
- JP-A- 2005 338 240
- US-A1- 2015 091 986
- US-A1- 2019 002 718
- US-A1- 2021 122 938

## Description

### BACKGROUND

### Technical Field

The present disclosure relates to a curable composition, a cured product, a method of producing a cured product, and an apparatus for producing a cured product.

### Related Art

A technique called additive manufacturing (AM) has been known as a technique for forming a three-dimensional solid object (hereinafter may be referred to as "tridimensional formed object"). This technique is a technique for producing a tridimensional formed object by calculating a cross-sectional shape of the tridimensional formed object thinly sliced in a stacking direction, and forming a layered formed object (hereinafter may be referred to as "formed layer") along the cross-sectional shape thus calculated and providing a stack.

Examples of known apparatuses for producing a tridimensional formed object include a forming apparatus with an SLA (stereolithography) system (see, e.g., Japanese Patent No. 5605589 and Japanese Patent No. 5774825). Such a forming apparatus with a stereolithography system forms a tridimensional formed object including a cured product of a curable resin solution by curing and stacking the curable resin solution layer by layer with an ultraviolet laser.

Examples of known materials used in a curable resin solution in a forming apparatus with a stereolithography system include dimethylacrylate and urethane acrylate (see, e.g., Japanese Patent Application Publication No. 1998-101754).

In addition, a forming apparatus with a stereolithography system is also known to employ a radiation-curable composition containing a (meth)acrylate compound, a urethane (meth)acrylate compound, or the like (see, e.g., Japanese Patent Application No. 3971412).

Further reference may be made to curable compositions and methods of producing cured products disclosed in JP 2005338240 A, US 2021/122938 A1, US2019/002718 A1 and US2015/091986 A1.

### SUMMARY

An object of the present invention is to provide a curable composition that can prevent warpage during curing and produce a cured product having excellent forming accuracy and forming rate.

A curable composition according to embodiment of the present invention as a way to solve the problem contains a monofunctional acrylic monomer, a polyfunctional acrylic monomer, a polyfunctional acrylic-based oligomer, and a compound having a polyalkylene glycol structure, wherein the polyfunctional acrylic-based oligomer is at least one of a polyfunctional aliphatic urethane acrylate, a polyfunctional polyester acrylate, and a polyfunctional epoxy acrylate. The compound having a polyalkylene glycol structure has a molecular weight of 1,500 or more to 5,500 or less. The content of the compound having a polyalkylene glycol structure is 5 parts by mass or more to 15 parts by mass or less relative to 100 parts by mass of the total of the monofunctional acrylic monomer, the polyfunctional acrylic monomer, and the polyfunctional acrylic-based oligomer.

Embodiments of the present invention provides a curable composition that can prevent warpage during curing and produce a cured product having excellent forming accuracy and forming rate.

### BRIEF DESCRIPTION OF THE DRAWINGS

A more complete appreciation of embodiments of the present disclosure and many of the attendant advantages and features thereof can be readily obtained and understood from the following detailed description with reference to the accompanying drawings, wherein:
FIG. 1A is an explanatory diagram illustrating a method of producing a cured product according to an embodiment of the present invention;
FIG. 1B is an explanatory diagram illustrating a method of producing a cured product according to an embodiment of the present invention;
FIG. 1C is an explanatory diagram illustrating a method of producing a cured product according to an embodiment of the present invention;
FIG. 2A is an explanatory diagram illustrating a method of producing a cured product according to an embodiment of the present invention;
FIG. 2B is an explanatory diagram illustrating a method of producing a cured product according to an embodiment of the present invention;
FIG. 2C is an explanatory diagram illustrating a method of producing a cured product according to an embodiment of the present invention; and
FIG. 3 is a graph presenting results of evaluation of warpage at a film thickness of 300 nm in cured products in Examples 20 to 21 and Comparative Examples 1 to 3.

The accompanying drawings are intended to depict embodiments of the present disclosure and should not be interpreted to limit the scope thereof. The accompanying drawings are not to be considered as drawn to scale unless explicitly noted. Also, identical or similar reference numerals designate identical or similar components throughout the several views.

### DETAILED DESCRIPTION

In describing embodiments illustrated in the drawings, specific terminology is employed for the sake of clarity. However, the disclosure of this specification is not intended to be limited to the specific terminology so selected and it is to be understood that each specific element includes all technical equivalents that have a similar function, operate in a similar manner, and achieve a similar result.

Referring now to the drawings, embodiments of the present disclosure are described below. As used herein, the singular forms "a," "an," and "the" are intended to include the plural forms as well, unless the context clearly indicates otherwise.

### (Curable Composition)

The curable composition according to the present embodiment contains a monofunctional acrylic monomer, a polyfunctional acrylic monomer, a polyfunctional acrylic-based oligomer, and a compound having a polyalkylene glycol structure, preferably contains a polymerization initiator, and further contains another component as appropriate.

The compound having a polyalkylene glycol structure has a molecular weight of 1,500 or more to 5,500 or less, and the content of the compound having a polyalkylene glycol structure is 5 parts by mass or more to 15 parts by mass or less relative to 100 parts by mass of the total of the monofunctional acrylic monomer, the polyfunctional acrylic monomer, and the polyfunctional acrylic-based oligomer.

The curable composition according to the present embodiment is based on the inventors' finding of the following problems in conventional techniques.

That is, conventional curable compositions primarily contain a low-strength material such as a resin, and have a problem in that production of a formed object with high hardness needs addition of an epoxy resin and the like and exposure to heat for a long duration for secondary curing. A typical acrylic resin also has a problem in that it forms significantly large warpage during curing and thus generates warpage of a cured product upon brief irradiation with light in a dose sufficient to cause curing, therefore providing poor forming accuracy and leading to failure in forming. This creates a problem in that slow irradiation with low emission energy for supplying required cumulative dose of light needs time for layer-by-layer curing and reduces a forming rate.

The inventors earnestly investigated to solve the aforementioned objectives, and consequently found that the curable composition according to the present embodiment can prevent such warpage during curing and provide a curable composition that can produce a cured product having excellent forming accuracy and forming rate. An acrylic-based monomer provides good light transmission and excellent hardness depth, and thus allows reduction in forming rate for a cured product. In addition, owing to reduced warpage and good forming accuracy, a cured product can be formed with large size.

A curable composition refers to a resin composition that contains a polymerizable compound such as a monomer or an oligomer and is c by applying active energy such as light or heat.

The curable composition is not particularly limited and can be appropriately selected according to a purpose, and examples thereof include, but are not limited to, photocurable compositions and heat-curable compositions. Among them, photocurable compositions are preferable.

### <Monofunctional Acrylic Monomer>

The monofunctional acrylic monomer is not particularly limited and can be appropriately selected according to a purpose. Example thereof include, but are not limited to, phenoxyethyl (meth)acrylate, tetrahydrofurfuryl (meth)acrylate, isobornyl (meth)acrylate, 2-hydroxyethyl (meth)acrylate, 4-hydroxybutyl (meth)acrylate, isobutyl (meth)acrylate, t-butyl (meth)acrylate, tetrahydrofurfuryl (meth)acrylate, isooctyl (meth)acrylate, 2-methoxyethyl (meth)acrylate, methoxytriethylene glycol (meth)acrylate, 2-ethoxyethyl (meth)acrylate, 3-methoxybutyl (meth)acrylate, ethoxyethyl (meth)acrylate, butoxyethyl (meth)acrylate, ethoxydiethylene glycol (meth)acrylate, ethoxydiethylene glycol (meth)acrylate, methoxydixylethyl (meth)acrylate, ethyldiglycol (meth)acrylate, cyclic trimethylolpropane formal mono(meth)acrylate, imido (meth)acrylate, isoamyl (meth)acrylate, ethoxylated succinic acid (meth)acrylate, trifluoroethyl (meth)acrylate, ω-carboxypolycaprolactone mono(meth)acrylate, cyclohexyl (meth)acrylate, benzyl (meth)acrylate, methylphenoxyethyl (meth)acrylate, 4-t-butylcyclohexyl (meth)acrylate, caprolactone-modified tetrahydrofurfuryl (meth)acrylate, tribromophenyl (meth)acrylate, ethoxylated tribromophenyl (meth)acrylate, 2-phenoxyethyl (meth)acrylate, phenoxydiethylene glycol (meth)acrylate, 2-hydroxy-3-phenoxypropyl (meth)acrylate, 1,4-cyclohexanedimethanol mono(meth)acrylate, 2- (2-ethoxyethoxy)ethyl (meth)acrylate, stearyl (meth)acrylate, diethylene glycol monobutylether (meth)acrylate, lauryl (meth)acrylate, isodecyl (meth)acrylate, 3,3,5-trimethylcyclohexanol (meth)acrylate, isooctyl (meth)acrylate, octyl/decyl (meth)acrylate, tridecyl (meth)acrylate, caprolactone (meth)acrylate, ethoxylated (4) nonylphenol (meth)acrylate, adamantyl (meth)acrylate, 2-methyl-2-adamantyl (meth)acrylate, dicyclopentenyl (meth)acrylate, dicyclopentanyl (meth)acrylate, dicyclopentenyloxyethyl (meth)acrylate, 2-hydroxypropyl (meth)acrylate, 2-hydroxybutyl (meth)acrylate, isobutyl (meth)acrylate, phenoxyethyl (meth)acrylate, (2-methyl-2-ethyl-1,3-dioxolane-4-yl)methyl (meth)acrylate, lauryl (meth)acrylate, and cyclic trimethylolpropaneformal (meth)acrylate.

Each of these may be used alone or in combination with others.

### <Polyfunctional Acrylic Monomer>

The polyfunctional acrylic monomer is not particularly limited and can be appropriately selected according to a purpose. Example thereof include, but are not limited to, bifunctional acrylic monomers and tri- or more functional acrylic monomers.

The bifunctional acrylic monomer is not particularly limited and can be appropriately selected according to a purpose. Examples thereof include, but are not limited to, neopentyl glycol di(meth)acrylate, (poly)ethylene glycol di(meth)acrylate, diethylene glycol di(meth)acrylate, triethylene glycol di(meth)acrylate, tetraethylene glycol di(meth)acrylate, (poly)propylene glycol di(meth)acrylate, dipropylene glycol di(meth)acrylate, (poly)tetramethylene glycol di(meth)acrylate, propyleneoxide (PO) adduct di(meth)acrylate of bisphenol A, ethoxylated neopentyl glycol di(meth)acrylate, propoxylated neopentyl glycol di(meth)acrylate, ethyleneoxide (EO) adduct di(meth)acrylate of bisphenol A, bis (4-(meth)acryloxy polyethoxyphenyl) propane, diallyl phthalate, 1,6-hexanediol di(meth)acrylate, ethoxylated 1,6-hexanediol di(meth)acrylate, 1,4-butanediol di(meth)acrylate, 1,9-nonanediol di(meth)acrylate, 1,3-butyleneglycol di(meth)acrylate, 1,10-decanedioldi(meth)acrylate, 2-n-butyl-2-ethyl 1,3-propanediol di(meth)acrylate, hydroxypivalic acid neopentyl glycol di(meth)acrylate, dimethyloltricyclodecane di(meth)acrylate, bisphenol A diglycidylether (meth)acrylic acid adduct, and modified bisphenol A di(meth)acrylate.

Each of these may be used alone or in combination with others.

The tri- or more functional acrylic monomer is not particularly limited and can be appropriately selected according to a purpose. Examples thereof include, but are not limited to, EO-modified pentaerythritol tri(meth)acrylate, PO-modified pentaerythritol tri(meth)acrylate, EO-modified pentaerythritol tetra(meth)acrylate, PO-modified pentaerythritol tetra(meth)acrylate, EO-modified dipentaerythritol tetra(meth)acrylate, PO-modified dipentaerythritol tetra(meth)acrylate, EO-modified trimethylolpropane tri(meth)acrylate, PO-modified trimethylolpropane tri(meth)acrylate, EO-modified tetramethylolmethane tetra(meth)acrylate, PO-modified tetramethylolmethane tetra(meth)acrylate, pentaerythritol tri(meth)acrylate, pentaerythritol tetra(meth)acrylate, dipentaerythritol tetra(meth)acrylate, trimethylolpropane tri(meth)acrylate, trimethylolpropaneethoxy tri(meth)acrylate, tricyclodecanedimethanol di(meth)acrylate, tetramethylolmethane tetra(meth)acrylate, trimethylolethane tri(meth)acrylate, tetramethylolmethane tri(meth)acrylate, modified glycerintri(meth)acrylate, caprolactone-modified dipentaerythritol hexa(meth)acrylate, dipentaerythritol hexa(meth)acrylate, pentaerythritol tri(meth)acrylate tolylene diisocyanate urethane prepolymer, pentaerythritol tri(meth)acrylate hexamethylene diisocyanate urethane prepolymer, and ditrimethylolpropane tetra(meth)acrylate.

Each of these may be used alone or in combination with others.

### <Polyfunctional Acrylic-based Oligomer>

The polyfunctional acrylic-based oligomer is at least one of a polyfunctional aliphatic urethane acrylate, a polyfunctional polyester acrylate, and a polyfunctional epoxy acrylate.

Even when corresponding to the polyfunctional acrylic-based oligomer, a compound having a polyalkylene glycol structure and a molecular weight of 1,500 or more to 5,500 or less is treated as the compound having a polyalkylene glycol structure described later.

The polyfunctional aliphatic urethane acrylate is not particularly limited and can be appropriately selected according to a purpose. Examples thereof include, but are not limited to, bifunctional aliphatic urethane acrylate such as EBECRYL series 230, 270 and 8402 (any of these are manufactured by Daicel-Allnex Ltd.); and tri- or more functional aliphatic urethane acrylate.

The polyfunctional polyester acrylate is not particularly limited and can be appropriately selected according to a purpose. Examples thereof include, but are not limited to, polyester acrylate (acrylic acid multimer ester) such as VISCOAT #190D (manufactured by Osaka Organic Chemical Industry Ltd., ethoxyethoxyethyl acrylate).

The polyfunctional epoxy acrylate is not particularly limited and can be appropriately selected according to a purpose. Examples thereof include, but are not limited to, epoxy acrylate such as EBECRYL 600 (manufactured by Daicel-Allnex Ltd.).

### <Compound Having Polyalkylene Glycol Structure>

The compound having a polyalkylene glycol structure is not particularly limited and can be appropriately selected according to a purpose. Preferred examples thereof include, but are not limited to, polyalkylene glycol and surfactants having a polyalkylene glycol structure.

Each of these may be used alone or in combination with others. It is preferred to combine polyalkylene glycol and a surfactant having a polyalkylene glycol structure.

Examples of the polyalkylene glycol include, but are not limited to, polyethylene glycol and polypropylene glycol.

Examples of the polypropyleneglycol include, but are not limited to, EXCENOL series 3020, 2020 and 5030 (any of these are manufactured by AGC Inc.); PP-4000 and GP-4000V (any of these are manufactured by Sanyo Chemical Industries, Ltd.), and polypropyleneglycol, triol type (manufactured by FUJIFILM Wako Pure Chemical Corporation).

Examples of the polyethylene glycol include, but are not limited to, polyethylene glycol 4000 (manufactured by FUJIFILM Wako Pure Chemical Corporation).

Preferred examples of the surfactant having a polyalkylene glycol structure include, but are not limited to, non-ionic surfactants, fluorine-based surfactants, and silicone-based surfactants.

Examples of the non-ionic surfactant include, but are not limited to, NEWPOL 50HB-5100 (manufactured by Sanyo Chemical Industries, Ltd.); and EPAN (DKS Co., Ltd.).

Examples of the fluorine-based surfactant include, but are not limited to, MEGAFACE F563 (manufactured by DIC Corporation); and SURFLON S-243 (manufactured by AGC Seimi Chemical Co., Ltd.).

Examples of the silicone-based surfactant include, but are not limited to, TEGO WET270 (manufactured by Evonik Industries AG); and BYK series 3500, 377 and 3510 (all of these are manufactured by BYK-Chemie GmbH).

The compound having a polyalkylene glycol structure has a molecular weight of 1,500 or more, preferably 1,500 or more to 5,500 or less.

When the molecular weight is 1,500 or more, the compound having a polyalkylene glycol structure is not taken in a macromolecular chain and adjusts the rate of polymerization with various oligomers during the curing process, thereby allowing excellent reduction in warpage during curing even in formation of a curable composition layer with a thickness of 200 µm or more. When the molecular weight is 5,500 or less, the compound has advantages in being compatible with a reaction solution and causing neither separation nor precipitation for a long duration.

The content of the compound having a polyalkylene glycol structure is 3 parts by mass or more to 20 parts by mass or less, preferably 5 parts by mass or more to 15 parts by mass or less, relative to 100 parts by mass of the total of the monofunctional acrylic monomer, the polyfunctional acrylic monomer, and the polyfunctional acrylic-based oligomer.

When the content is 5 parts by mass or more, warpage during curing can be better reduced even in formation of a curable composition layer having a thickness of 200 µm to 300 µm. When the content is 15 parts by mass or less, the compound has advantages in being compatible with a reaction solution and causing neither separation nor precipitation for a long duration.

### <Polymerization Initiator>

A polymerization initiator refers to a substance that absorbs active energy such as light or heat and thereby initiates a polymerization reaction of the aforementioned polymerizable compound.

The polymerization initiator is not particularly limited and can be appropriately selected according to a purpose. Examples thereof include, but are not limited to, radical polymerization initiators, cationic polymerization initiators, and anionic polymerization initiators. Radical polymerization initiators are preferred. Each of these may be used alone or in combination with others.

The content of the polymerization initiator relative to the total of the curable composition is not particularly limited, can be selected according to a purpose, and is preferably, e.g., 0.01% by weight or more to 5% by weight or less.

The radical polymerization initiator is not particularly limited and can be appropriately selected according to a purpose. Examples thereof include, but are not limited to, aromatic ketones, acylphosphine oxide compounds, aromatic onium salt compounds, organic peroxides, thio compounds (e.g., thioxanthone compounds and thiophenyl-group-containing compounds), hexaaryl biimidazole compounds, ketoxime ester compounds, borate compounds, azinium compounds, metallocene compounds, active ester compounds, carbon-halogen-bond-containing compounds, and alkylamine compounds.

The cationic polymerization initiator is not particularly limited and can be appropriately selected according to a purpose. Examples thereof include, but are not limited to, onium salts such as aryl sulfonium salts and aryl iodonium salts; N-vinylcarbazol; thioxanthone compounds; and anthracene compounds such as 9,10-dibutoxyanthracene.

The anionic polymerization initiator is not particularly limited and can be appropriately selected according to a purpose. Examples thereof include, but are not limited to, primary amines or secondary amines such as o-nitrobenzyl carbamate, α,α-dimethylbenzyl carbamate, α-keto carbamate derivatives, and N-hydroxyimide carbamate; ammonium salts of phenylglyoxylate; benzhydryl ammonium salts; N-benzophenonemethyl-tri-N-alkylammonium borate salts; borate salts of quaternary α-ammonium acetophenone salts; dithiocarbamate, thiocyanate, and other couterions, or salts containing amineimide derivatives.

### <Other Components>

Other components are not particularly limited and can be appropriately selected according to a purpose. Examples thereof include, but are not limited to, antifoamers, sizing agents, cross linkers, viscosity reducers, surface treatment agents, plasticizers, smoothing agents, and solvents.

### (Cured product)

The cured product (also referred to as e.g., formed object) according to the present embodiment is formed of the curable composition according to the present embodiment, and can be obtained by emitting active energy such as light or heat onto the curable composition to cause curing.

The cured product according to the present embodiment is not particularly limited as long as said cured product is produced by curing the curable composition according to the present embodiment. The cured product according to the present embodiment is not limited to a material produced by the method of producing a cured product or the apparatus for producing a cured product according to the present embodiment, and may be, e.g., produced by a forming apparatus with an inkjet system.

The cured product according to the present embodiment also preferably has a specific flexural strength of 30 MPa or more. With having a specific flexural strength of 30 MPa or more, the cured product can be more preferably used for a member or the like desirably having some strength. The specific flexural strength of the cured product can be derived by a test in accordance with JIS K7171 using a precision universal testing machine (AUTOGRAPH).

### (Method of Producing Cured product and Apparatus for Producing Cured product)

The method of producing a cured product according to the present embodiment includes a supplying step and a curing step, and further includes other steps as appropriate.

The apparatus for producing a cured product according to the present embodiment includes a storage container, a supplying unit, and a curing unit, and further includes other units as appropriate.

The method of producing a cured product can be preferably performed by the apparatus for producing a cured product; the supplying step can be preferably performed by the supplying unit, the curing step can be preferably performed by the curing unit, and other steps can be preferably performed by other units.

In other words, the apparatus for producing a cured product according to the present embodiment is synonymous with performing the method of producing a cured product according to the present embodiment. Accordingly, description will be made mainly for the apparatus for producing a cured product according to the present embodiment, thereby also disclosing detail of the method of producing a cured product according to the present embodiment.

### <Storage Container>

The storage container includes the curable composition and a container, and is a storage container in which the curable composition is contained in the container.

Examples of the container include, but are not limited to, glass bottles, plastic containers, plastic bottles, stainless bottles, 18-liter cans, and drum cans.

### <Supplying Unit and Supplying Step>

The supplying unit is a unit to supply the curable composition onto a stage or beneath a stage.

The supplying step is a step to supply the curable composition onto a stage or beneath a stage, and can be preferably performed by the supplying unit.

The supplying unit is not particularly limited and can be appropriately selected according to a purpose. Examples thereof include, but are not limited to, a mechanism to supply the curable composition by lowering a stage that is employed in a forming apparatus with a stereolithography system according to a free liquid surface method and used for forming a cured product (formed object) thereon. Another example of the supplying unit may be a mechanism to supply the curable composition by raising a stage that is employed in a forming apparatus with a stereolithography system according to a constrained liquid surface method and used for forming a formed object thereon.

The forming apparatus with a stereolithography system according to a free liquid surface method supplies the curable composition onto a stage by lowering, by a predetermined distance, the stage placed in a tank to which the curable composition is supplied. The curable composition thus supplied is cured by the curing unit described later, thereby forming a thin layer including a cured product.

Since the curable composition thus supplied can provide a surface with less flatness depending on viscosity of the curable composition, the supplying unit may have a smoothing mechanism that smoothens a surface of the curable composition, as appropriate.

The forming apparatus with a stereolithography system according to a regulated liquid surface method supplies the curable composition beneath a stage by raising, by a predetermined distance, the stage placed in a tank to which the curable composition is supplied. The curable composition thus supplied is cured by the curing unit described later, thereby forming a thin layer including a cured product.

### <Curing Unit and Curing Step>

The curing unit is a unit to cure at least a part of the curable composition thus supplied by emitting, thereto, light with a wavelength of 350 nm to 420 nm.

The curing step is a step to cure at least a part of the curable composition thus supplied by emitting, thereto, light with a wavelength of 350 nm to 420 nm, and can be preferably performed by the curing unit.

The curing unit is not particularly limited and can be appropriately selected according to a purpose, as long as said curing unit allows emission of light that can apply energy to and cure the curable composition. Examples of the curing unit include, but are not limited to, fluorescent lamps, metal halide lamps, mercury lamps, xenon lamps, discharge tubes such as neon tubes, filament lamp, LEDs (light emitting diodes), semiconductor laser irradiators (laser diodes), organic EL (electro-luminescence), inorganic EL, ultraviolet (UV) irradiators, and DLP^{®} (digital light processing) light sources.

In irradiation with light, the curing unit may focus on and emit light to a desired site with moving to a desired position, or may emit light collectively to a certain area. The area to be irradiated can be appropriately changed, and irradiation on a narrower area provides a more sophisticated, cured product. With regard to the direction of light emitted by the curing unit, the light may be emitted from above or from below a stage.

A technique of emitting light on a desired site to cure the curable composition is not particularly limited and can be selected according to a purpose. Examples thereof include, but are not limited to, a technique of changing an irradiated position with use of a fθ lens and a Galvano mirror, a technique of changing an irradiated position with use of a fθ lens and a polygon mirror, a technique of moving the curing unit to a desired position, and a technique of moving a stage relative to the curing unit.

Light emitted by the curing unit is not particularly limited as long as such light is light having a wavelength within the range of 350 nm to 420 nm. Examples thereof include, but are not limited to, electromagnetic waves in the range of ultraviolet to visible light. Light emitted by the curing unit may be light emitted directly by the curing unit, or light extracted via an optical filter.

The apparatus for producing a cured product can perform a predetermined number of iterations of the supplying step to supply the curable composition by the supplying unit, and the curing step to cure the curable composition by the curing unit, thereby stack a thin layer including a cured product of the curable composition, and produce a formed object.

### <Other units and Other Steps>

Other units are not particularly limited and can be appropriately selected according to a purpose. Examples thereof include, but are not limited to, a heating unit and a stirring unit.

Other steps are not particularly limited and can be appropriately selected according to a purpose. Examples thereof include, but are not limited to, a heating step and a stirring step.

The heating step can be preferably performed by the heating unit, the stirring step can be preferably performed by the stirring unit, and the smoothing step can be preferably performed by the smoothing unit.

The heating unit is not particularly limited and can be appropriately selected according to a purpose, as long as said heating unit can heat a cured product of the curable composition. Examples thereof include, but are not limited to, an infrared (IR) heater.

The heating unit provides further improvement in heat resistance and specific strength of a cured product of the curable composition by heating the cured product at timing at least either during or after production of a formed object.

The stirring unit is not particularly limited and can be appropriately selected according to a purpose, as long as said stirring unit can stir the curable composition. Examples thereof include, but are not limited to, a mechanism that performs stirring by rotating a blade-shaped member, and a mechanism that performs stirring by vibration generated from ultrasonic.

Timing when the stirring unit stirs the curable composition is not particularly limited and can be appropriately selected according to a purpose. Examples thereof include, but are not limited to, timing before supply of the curable composition by the supplying unit.

Since stirring of the curable composition by the stirring unit temporally reduces viscosity of the curable composition, even a highly viscous curable composition facilitates production of a formed object, as well as allows prevention of uneven dispersion of each component in the curable composition and facilitates production of a highly-sophisticated, cured product.

The apparatus for producing a cured product according to the present embodiment facilitates production of a cured product even with use of a highly viscous curable composition, and thus is preferably the aforementioned apparatus for producing a cured product according to a constrained liquid surface method. As examples of the apparatus for producing a cured product according to a constrained liquid surface method, an apparatus for producing a cured product according to one-dimensional constraining method described in Japanese Patent No. 5774825 and an apparatus for producing a cured product according to two-dimensional regulation described in Japanese Patent No. 5605589 can be used.

In two-dimensional constraining method (e.g., 3D printers manufactured by Formlabs Inc.), since a curable composition is interposed between both sides, i.e., between a stage side and an opposed side, during laser irradiation, a state of curing is less observed, and temporal change of a state of curing may make it difficult to judge completion of curing. By contrast, a free liquid surface method and an inkjet method have advantage in significantly highly contributing to prevention of warpage during forming.

Hereinafter the method of producing a cured product according to the present embodiment will be described with reference to the drawings, but the present invention is not limited to the embodiments described below.

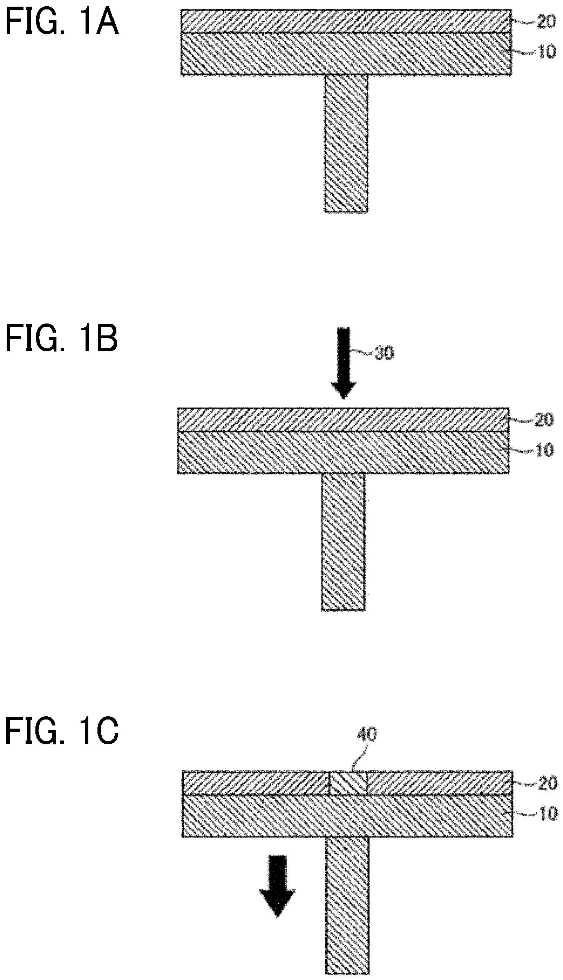

FIGs. 1A to 1C are explanatory diagrams illustrating the method of producing a cured product according to an embodiment.

First, as illustrated in FIG. 1A, at a supplying step, a curable composition is supplied, thereby forming a thin layer 20 on a stage 10.

Next, as illustrated in FIG. 1B, at a curing step, at least a part of the thin layer 20 is irradiated with light 30 from above the stage 10 and cured.

Then, as illustrated in FIG. 1C, curing at least a part of the thin layer 20 results in formation of a cured product 40. Subsequently, at a supplying step, the stage 10 is lowered in a direction of the arrow in FIG. 1C, and the curable composition is supplied, thereby forming a thin layer that is to be a next layer.

In this manner, in the method of producing a cured product according to the present embodiment, a supplying step and a curing step are repeated, thereby stack the cured product 40 on the stage 10 to produce a formed object (tridimensional formed object).

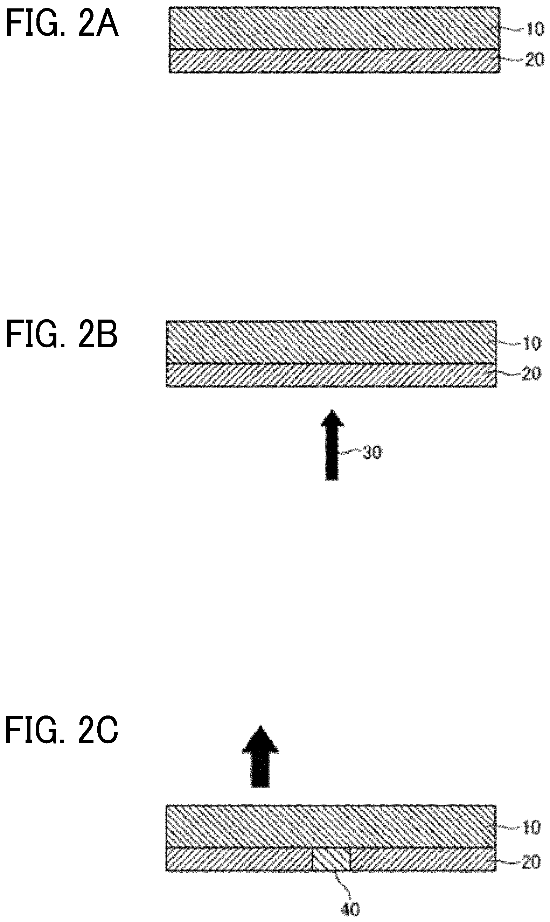

FIGs. 2A to 2C are explanatory diagrams illustrating the method of producing a cured product according to another embodiment.

First, as illustrated in FIG. 2A, at a supplying step, a curable composition is supplied, thereby forming a thin layer 20 beneath a stage 10.

Next, as illustrated in FIG. 2B, at a curing step, at least a part of the thin layer 20 is irradiated with light 30 from below the stage 10 and cured.

Then, as illustrated in FIG. 2C, curing at least a part of the thin layer 20 results in formation of a cured product 40. Subsequently, at a supplying step, the stage 10 is raised in a direction of the arrow in FIG. 2C, and the curable composition is supplied, thereby forming a thin layer that is to be a next layer.

In this manner, in another embodiment of the method of producing a cured product according to the present embodiment, a supplying step and a curing step are repeated, thereby stack the cured product 40 beneath the stage 10 to produce a formed object (tridimensional formed object).

### [Examples]

The present invention will now be more particularly described by way of examples, but the present invention is not limited to the following examples.

Hereinafter, in the examples, "part" represents "part by mass", and "%" represents "% by mass".

### (Preparation Example 1)

### Preparation of Cyan Particle Dispersion Liquid (A)

A preparation was made by adding 42.5 parts by mass of phenoxyethylacrylate (manufactured by Osaka Organic Chemical Industry Ltd.), 1.5 parts by mass of a polymer pigment dispersant (DISPER BYK-168, manufactured by BYK-Chemie GmbH), and 6.0 parts by mass of a cyan pigment (LIONOL BLUE FG-7330, manufactured by Toyocolor Co., Ltd.), mixed and stirred with a stirrer for 1 hour, followed by stirring with a bead mill for 2 hours, thereby preparing a cyan particle dispersion liquid (A).

### (Example 1)

### <Preparation of Curable Composition 1>

As presented in Table 1-1, (a) 17.5 parts by mass of isobornylacrylate (manufactured by Osaka Organic Chemical Industry Ltd.) as a monofunctional acrylic monomer, (b) 65.0 parts by mass of ethyleneoxide (EO)-modified bisphenol A diacrylate (manufactured by Daicel-Allnex Ltd.) as a polyfunctional acrylic monomer, (c) EBECRYL600 (manufactured by Daicel-Allnex Ltd., epoxy acrylate) as a polyfunctional acrylic oligomer, (d) 3.0 parts by mass of EXCENOL3020 (manufactured by AGC Inc., Mw: 3200, polypropyleneglycol) and 2.0 parts by mass of TEGO WET270 (manufactured by Evonik Industries AG, polyethersiloxane copolymer) as compounds having a polyalkylene glycol structure, 0.1 parts by mass of a cyan particle dispersion liquid (A) as a pigment dispersion, and 1.5 parts by mass of Omnirad TPO (manufactured by IGM Resins B.V, 2,4,6-trimethylbenzoyl diphenylphosphine oxide) as a polymerization initiator were mixed, serially added with stirring, then stirred for 6 hours, thereby preparing Curable composition 1 in Example 1.

### <Production of Cured product 1>

A curable composition layer was formed with use of Curable composition 1 contained a polymerization initiator, by a 3W semiconductor excitation solid laser (355 nm) mounted with the photoforming 3D printer DARAM3 (manufactured by D-MEC Ltd.), so as to provide a size of length 50 mm × width 50 mm and a predetermined film thickness (100 µm, 200 µm, 300 µm, and 400 µm). Active energy rays were irradiated between 5 mJ/cm² and 55 mJ/cm² to cure the curable composition, thereby producing cured films with three steps of thicknesses: 100 µm, 200 µm, 300 µm, and 400 µm. The apparatus used here was adjusted for laser power so as to provide a thickness of one layer identical with each predetermined film thickness, and a desired thickness was achieved without moving a stage.

A curable composition attaching to a surface of the cured film thus obtained was washed with isopropyl alcohol (IPA), wiped out and cleaned, and left to stand for 3 hours, thereby producing a cured product having each thickness.

### <Evaluations>

The curable compositions and the cured products thus obtained was evaluated for warpage of a cured product, and curing depth of the curable composition, as shown below. The results are presented in Table 1.

### <<Warpage of Cured product>>

The central part of the cured product thus obtained with each thickness was contacted with a horizontal surface, and then a distance from an edge part to the horizontal surface was measured as warpage of the cured product with a ruler, followed by evaluation in accordance with the following criteria.

### [Evaluation Criteria]

+++: 0 mm or more to less than 1 mm
++: 1 mm or more to less than 2 mm
+: 2 mm or more to less than 4 mm
-: 4 mm or more

### <<Curing Depth of Curable Composition>>

A cured film was produced by curing in the same manner as in the production of Cured product 1 except for forming one layer of the curable composition having a thickness of 400 µm in production of Cured product 1, emitting, thereto, active energy rays with 55 mJ/cm², thereby producing a cured film. An uncured, curable composition attaching to a surface of the cured film thus obtained was wiped out and cleaned, thereby producing a cured product. The thicknesses of any three points in the cured product successfully cured by irradiation of active energy rays having 55 mJ/cm² were measured with a high-precision digimatic micrometer (MDH25MB, manufactured by Mitutoyo Corporation), and the average thickness was derived and defined as curing depth. Evaluation was made in accordance with the following criteria.

### [Evaluation Criteria]

+++: produced a cured film cured at a depth of up to 400 µm
++: produced a cured film cured at a depth of 300 µm or more to less than 400 µm
+: produced a cured film cured at a depth of 250 µm or more to less than 300 µm
-: produced a cured film cured at a depth of less than 250 µm

### (Examples 2 to 36)

Curable compositions 2 to 36 and Cured products 2 to 36 in Examples 2 to 36 were prepared in the same manner as in Example 1 except for changing the type and parts by mass of components as presented in Tables 1 to 6 in Example 1, and evaluated in the same manner as in Example 1. The results are presented in Tables 1 to 6.

### (Comparative Examples 1 to 6)

Curable compositions a to f and Cured products a to f in Comparative Examples 1 to 6 were prepared in the same manner as in Example 1 except for changing the type and parts by mass of components as presented in Table 7 in Example 1, and evaluated in the same manner as in Example 1. The results are presented in Table 7.

Product names and manufacturers of materials used in Examples and Comparative Examples in Tables 1 to 7 are as presented in Tables 8 to 9.

Conventional acrylic-based 3D forming ink has had a problem in generating large warpage or bend and failing to produce a cured product (formed object) with good forming accuracy. Actually, the results demonstrated that, as presented in Comparative Example 1, no inclusion of (d) a compound having a polyalkylene glycol structure leads to a warpage of 14 mm in a cured product having a thickness of 300 µm, causing poor forming accuracy.

By contrast, as presented in Examples 1 to 35, it was revealed that inclusion of (d) a compound having a polyalkylene glycol structure allows production of a cured product having less warpage or bend and excellent forming accuracy even with use of a curable composition that is an acrylic-based ink.

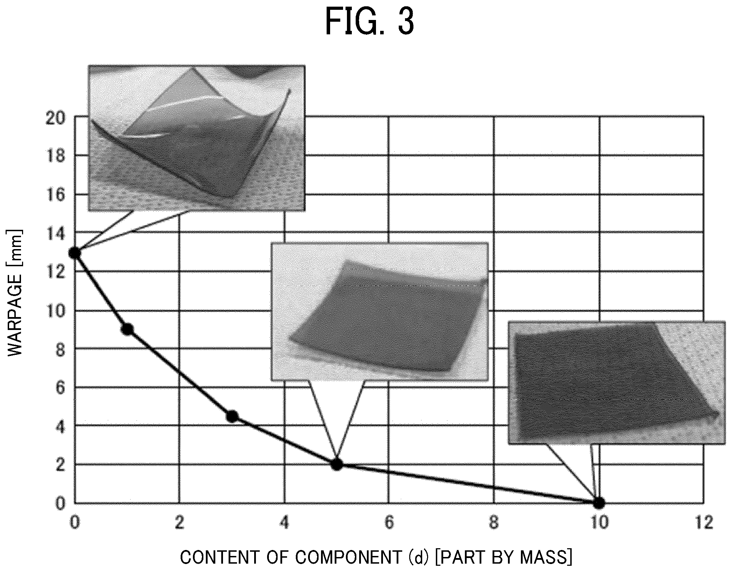

FIG. 3 shows results of evaluation of warpage in a cured product having a film thickness of 300 µm for Comparative Examples 1 to 3, and Examples 20 to 21.

The results demonstrated that warpage was reduced depending on the content of (d) a compound having a polyalkylene glycol structure.

**Table 1**

| | Product name | Example | | | | | |
|---|---|---|---|---|---|---|---|
| | | 1 | 2 | 3 | 4 | 5 | 6 |
| (a) Monofunctional acrylic monomer | isobornylacrylate | 17.5 | 17.5 | 17.5 | | | |
| | tetrahydrofurfuryl acrylate | | | | 17.5 | | |
| | phenoxyethylacrylate | | | | | 17.5 | |
| | lauryl acrylate | | | | | | 17.5 |
| (b) Polyfunctional acrylic monomer | EO-modified bisphenol A diacrylate | 65.0 | | | 65.0 | 65.0 | 65.0 |
| | trimethylolpropaneethoxy triacrylate | | 65.0 | | | | |
| | tricyclodecanedimethanol diacrylate | | | 65.0 | | | |
| (c) Polyfunctional acrylic oligomer | EBECRYL600 | 17.5 | 17.5 | 17.5 | 17.5 | 17.5 | 17.5 |
| | EBECRYL230 | | | | | | |
| | EBECRYL270 | | | | | | |
| | EBECRYL8402 | | | | | | |
| (d) Compound having polyalkylene glycol structure | EXCENOL3020 | 3.0 | 3.0 | 3.0 | 3.0 | 3.0 | 3.0 |
| | EXCENOL2020 | | | | | | |
| | EXCENOL5030 | | | | | | |
| | PP-4000 | | | | | | |
| | GP-4000V | | | | | | |
| | polyethylene glycol 4000 | | | | | | |
| | polypropyleneglycol, triol type, Mw1500 | | | | | | |
| | NEWPOL 50HB-5100 | | | | | | |
| | EPAN | | | | | | |
| | TEGO WET270 | 2.0 | 2.0 | 2.0 | 2.0 | 2.0 | 2.0 |
| | MEGAFACE F563 | | | | | | |
| | SURFLON S-243 | | | | | | |
| | BYK 3500 | | | | | | |
| | BYK 377 | | | | | | |
| | BYK 3510 | | | | | | |
| Comparison (d) | GP-1000 | | | | | | |
| | triethylene glycol | | | | | | |
| | IPA | | | | | | |
| Initiator | Omnirad TPO | 1.5 | 1.5 | 1.5 | 1.5 | 1.5 | 1.5 |
| Pigment dispersion | Cyan particle dispersion (A) | 0.1 | 0.1 | 0.1 | 0.1 | 0.1 | 0.1 |
| Total (parts by weight) | | 106.6 | 106.6 | 106.6 | 106.6 | 106.6 | 106.6 |
| Evaluation results | Warpage in a film thickness of 400 µm | +++ | +++ | +++ | +++ | +++ | +++ |
| | Warpage in a film thickness of 300 µm | +++ | +++ | +++ | +++ | +++ | +++ |
| | Warpage in a film thickness of 200 µm | +++ | +++ | +++ | +++ | +++ | +++ |
| | Warpage in a film thickness of 100 µm | +++ | +++ | +++ | +++ | +++ | +++ |
| | Curring depth | +++ | +++ | +++ | +++ | +++ | +++ |

**Table 2**

| | Product name | Example | | | | | |
|---|---|---|---|---|---|---|---|
| | | 7 | 8 | 9 | 10 | 11 | 12 |
| (a) Monofunctional acrylic monomer | isobornylacrylate | 17.5 | 17.5 | 17.5 | | | |
| | tetrahydrofurfuryl acrylate | | | | | | 17.5 |
| | phenoxyethylacrylate | | | | | | |
| | lauryl acrylate | | | | 17.5 | 17.5 | |
| (b) Polyfunctional acrylic monomer | EO-modified bisphenol A diacrylate | 65.0 | 65.0 | 65.0 | | | |
| | trimethylolpropaneethoxy triacrylate | | | | 65.0 | | |
| | tricyclodecanedimethanol diacrylate | | | | | 65.0 | 65.0 |
| (c) Polyfunctional acrylic oligomer | EBECRYL600 | | | | | 17.5 | |
| | EBECRYL230 | 17.5 | | | 17.5 | | |
| | EBECRYL270 | | 17.5 | | | | 17.5 |
| | EBECRYL8402 | | | 17.5 | | | |
| (d) Compound having polyalkylene glycol structure | EXCENOL3020 | 3.0 | 3.0 | 3.0 | 3.0 | 3.0 | 3.0 |
| | EXCENOL2020 | | | | | | |
| | EXCENOL5030 | | | | | | |
| | PP-4000 | | | | | | |
| | GP-4000V | | | | | | |
| | polyethylene glycol 4000 | | | | | | |
| | polypropyleneglycol, triol type, Mw1500 | | | | | | |
| | NEWPOL 50HB-5100 | | | | | | |
| | EPAN | | | | | | |
| | TEGO WET270 | 2.0 | 2.0 | 2.0 | 2.0 | 2.0 | 2.0 |
| | MEGAFACE F563 | | | | | | |
| | SURFLON S-243 | | | | | | |
| | BYK 3500 | | | | | | |
| | BYK 377 | | | | | | |
| | BYK 3510 | | | | | | |
| Comparison (d) | GP-1000 | | | | | | |
| | triethylene glycol | | | | | | |
| | IPA | | | | | | |
| Initiator | Omnirad TPO | 1.5 | 1.5 | 1.5 | 1.5 | 1.5 | 1.5 |
| Pigment dispersion | Cyan particle dispersion (A) | 0.1 | 0.1 | 0.1 | 0.1 | 0.1 | 0.1 |
| Total (parts by weight) | | 106.6 | 106.6 | 106.6 | 106.6 | 106.6 | 106.6 |
| Evaluation results | Warpage in a film thickness of 400 µm | ++ | ++ | ++ | ++ | ++ | ++ |
| | Warpage in a film thickness of 300 µm | +++ | +++ | +++ | +++ | +++ | +++ |
| | Warpage in a film thickness of 200 µm | +++ | +++ | +++ | +++ | +++ | +++ |
| | Warpage in a film thickness of 100 µm | +++ | +++ | +++ | +++ | +++ | +++ |
| | Curring depth | ++ | ++ | ++ | ++ | ++ | ++ |

**Table 3**

| | Product name | Example | | | | | |
|---|---|---|---|---|---|---|---|
| | | 13 | 14 | *15* | 16 | 17 | 18 |
| (a) Monofunctional acrylic monomer | isobornylacrylate | | | | | | 17.5 |
| | tetrahydrofurfuryl acrylate | | | 17.5 | | | |
| | phenoxyethylacrylate | | 17.5 | | 17.5 | | |
| | lauryl acrylate | 17.5 | | | | 17.5 | |
| (b) Polyfunctional acrylic monomer | EO-modified bisphenol A diacrylate | 65.0 | 65.0 | 65.0 | | | 65.0 |
| | trimethylolpropaneethoxy triacrylate | | | | 65.0 | | |
| | tricyclodecanedimethanol diacrylate | | | | | 65.0 | |
| (c) Polyfunctional acrylic oligomer | EBECRYL600 | | | | | | 17.5 |
| | EBECRYL230 | | | 17.5 | 17.5 | | |
| | EBECRYL270 | | | | | | |
| | EBECRYL8402 | 17.5 | 17.5 | | | 17.5 | |
| (d) Compound having polyalkylene glycol structure | EXCENOL3020 | 3.0 | 3.0 | 3.0 | 3.0 | 3.0 | 3.0 |
| | EXCENOL2020 | | | | | | |
| | EXCENOL5030 | | | | | | |
| | PP-4000 | | | | | | |
| | GP-4000V | | | | | | |
| | polyethylene glycol 4000 | | | | | | |
| | polypropyleneglycol, triol type, Mw1500 | | | | | | |
| | NEWPOL 50HB-5100 | | | | | | |
| | EPAN | | | | | | |
| | TEGO WET270 | 2.0 | 2.0 | 2.0 | 2.0 | 2.0 | |
| | MEGAFACE F563 | | | | | | |
| | SURFLON S-243 | | | | | | |
| | BYK 3500 | | | | | | 2.0 |
| | BYK 377 | | | | | | |
| | BYK 3510 | | | | | | |
| Comparison (d) | GP-1000 | | | | | | |
| | triethylene glycol | | | | | | |
| | IPA | | | | | | |
| Initiator | Omnirad TPO | 1.5 | 1.5 | 1.5 | 1.5 | 1.5 | 1.5 |
| Pigment dispersion | Cyan particle dispersion (A) | 0.1 | 0.1 | 0.1 | 0.1 | 0.1 | 0.1 |
| Total (parts by weight) | | 106.6 | 106.6 | 106.6 | 106.6 | 106.6 | 106.6 |
| Evaluation results | Warpage in a film thickness of 400 µm | ++ | ++ | ++ | ++ | ++ | ++ |
| | Warpage in a film thickness of 300 µm | +++ | +++ | ++ | ++ | ++ | ++ |
| | Warpage in a film thickness of 200 µm | +++ | +++ | ++ | ++ | ++ | ++ |
| | Warpage in a film thickness of 100 µm | +++ | +++ | ++ | ++ | ++ | ++ |
| | Curring depth | ++ | ++ | ++ | ++ | ++ | ++ |

**Table 4**

| | Product name | Example | | | | | |
|---|---|---|---|---|---|---|---|
| | | 19 | 20 | 21 | 22 | 23 | 24 |
| (a) Monofunctional acrylic monomer | isobornylacrylate | 17.5 | 17.5 | 17.5 | 17.5 | 17.5 | 17.5 |
| | tetrahydrofurfuryl acrylate | | | | | | |
| | phenoxyethylacrylate | | | | | | |
| | lauryl acrylate | | | | | | |
| (b) Polyfunctional acrylic monomer | EO-modified bisphenol A diacrylate | 65.0 | 65.0 | 65.0 | 65.0 | 65.0 | 65.0 |
| | trimethylolpropaneethoxy triacrylate | | | | | | |
| | tricyclodecanedimethanol diacrylate | | | | | | |
| (c) Polyfunctional acrylic oligomer | EBECRYL600 | 17.5 | 17.5 | 17.5 | 17.5 | 17.5 | 17.5 |
| | EBECRYL230 | | | | | | |
| | EBECRYL270 | | | | | | |
| | EBECRYL8402 | | | | | | |
| (d) Compound having polyalkylene glycol structure | EXCENOL3020 | 2.0 | 5.0 | 10.0 | 15.0 | | |
| | EXCENOL2020 | | | | | 5.0 | |
| | EXCENOL5030 | | | | | | 5.0 |
| | PP-4000 | | | | | | |
| | GP-4000V | | | | | | |
| | polyethylene glycol 4000 | | | | | | |
| | polypropyleneglycol, triol type, Mw1500 | | | | | | |
| | NEWPOL 50HB-5100 | | | | | | |
| | EPAN | | | | | | |
| | TEGO WET270 | 3.0 | | | | | |
| | MEGAFACE F563 | | | | | | |
| | SURFLON S-243 | | | | | | |
| | BYK 3500 | | | | | | |
| | BYK 377 | | | | | | |
| | BYK 3510 | | | | | | |
| Comparison (d) | GP-1000 | | | | | | |
| | triethylene glycol | | | | | | |
| | IPA | | | | | | |
| Initiator | Omnirad TPO | 1.5 | 1.5 | 1.5 | 1.5 | 1.5 | 1.5 |
| Pigment dispersion | Cyan particle dispersion (A) | 0.1 | 0.1 | 0.1 | 0.1 | 0.1 | 0.1 |
| Total (parts by weight) | | 106.6 | 106.6 | 111.6 | 116.6 | 106.6 | 106.6 |
| Evaluation results | Warpage in a film thickness of 400 µm | ++ | ++ | +++ | ++ | ++ | ++ |
| | Warpage in a film thickness of 300 µm | ++ | +++ | +++ | ++ | ++ | ++ |
| | Warpage in a film thickness of 200 µm | ++ | +++ | +++ | ++ | ++ | ++ |
| | Warpage in a film thickness of 100 µm | ++ | +++ | +++ | ++ | ++ | ++ |
| | Curring depth | ++ | ++ | +++ | ++ | ++ | ++ |

**Table 5**

| | Product name | Example | | | | | |
|---|---|---|---|---|---|---|---|
| | | 25 | 26 | 27 | 28 | 29 | 30 |
| (a) Monofunctional acrylic monomer | isobornylacrylate | 17.5 | 17.5 | 17.5 | 17.5 | 17.5 | 17.5 |
| | tetrahydrofurfuryl acrylate | | | | | | |
| | phenoxyethylacrylate | | | | | | |
| | lauryl acrylate | | | | | | |
| (b) Polyfunctional acrylic monomer | EO-modified bisphenol A diacrylate | 65.0 | 65.0 | 65.0 | 65.0 | 65.0 | 65.0 |
| | trimethylolpropaneethoxy triacrylate | | | | | | |
| | tricvclodecanedimethanol diacrylate | | | | | | |
| (c) Polyfunctional acrylic oligomer | EBECRYL600 | 17.5 | 17.5 | 17.5 | 17.5 | 17.5 | 17.5 |
| | EBECRYL230 | | | | | | |
| | EBECRYL270 | | | | | | |
| | EBECRYL8402 | | | | | | |
| (d) Compound having polyalkylene glycol structure | EXCENOL3020 | | | | | | |
| | EXCENOL2020 | | | | | | |
| | EXCENOL5030 | | | | | | |
| | PP-4000 | 5.0 | | | | | |
| | GP-4000V | | 5.0 | | | | |
| | polyethylene glycol 4000 | | | 5.0 | | | |
| | polypropyleneglycol, triol type, Mw1500 | | | | 5.0 | | |
| | NEWPOL 50HB-5100 | | | | | 5.0 | |
| | EPAN | | | | | | 5.0 |
| | TEGO WET270 | | | | | | |
| | MEGAFACE F563 | | | | | | |
| | SURFLON S-243 | | | | | | |
| | BYK 3500 | | | | | | |
| | BYK 377 | | | | | | |
| | BYK 3510 | | | | | | |
| Comparison (d) | GP-1000 | | | | | | |
| | triethylene glycol | | | | | | |
| | IPA | | | | | | |
| Initiator | Omnirad TPO | 1.5 | 1.5 | 1.5 | 1.5 | 1.5 | 1.5 |
| Pigment dispersion | Cyan particle dispersion (A) | 0.1 | 0.1 | 0.1 | 0.1 | 0.1 | 0.1 |
| Total (parts by weight) | | 106.6 | 106.6 | 106.6 | 106.6 | 106.6 | 106.6 |
| Evaluation results | Warpage in a film thickness of 400 µm | ++ | ++ | + | ++ | ++ | ++ |
| | Warpage in a film thickness of 300 µm | ++ | ++ | ++ | ++ | ++ | ++ |
| | Warpage in a film thickness of 200 µm | ++ | ++ | ++ | ++ | ++ | ++ |
| | Warpage in a film thickness of 100 µm | ++ | ++ | ++ | ++ | ++ | ++ |
| | Curring depth | ++ | ++ | ++ | ++ | ++ | ++ |

**Table 6**

| | Product name | Example | | | | | |
|---|---|---|---|---|---|---|---|
| | | 31 | 32 | 33 | 34 | 35 | 36 |
| (a) Monofunctional acrylic monomer | isobornylacrylate | 17.5 | 17.5 | 17.5 | 17.5 | 17.5 | 17.5 |
| | tetrahydrofurfuryl acrylate | | | | | | |
| | phenoxyethylacrylate | | | | | | |
| | lauryl acrylate | | | | | | |
| (b) Polyfunctional acrylic monomer | EO-modified bisphenol A diacrylate | 65.0 | 65.0 | 65.0 | 65.0 | 65.0 | 65.0 |
| | trimethylolpropaneethoxy triacrylate | | | | | | |
| | tricyclodecanedimethanol diacrylate | | | | | | |
| (c) Polyfunctional acrylic oligomer | EBECRYL600 | 17.5 | 17.5 | 17.5 | 17.5 | 17.5 | 17.5 |
| | EBECRYL230 | | | | | | |
| | EBECRYL270 | | | | | | |
| | EBECRYL8402 | | | | | | |
| (d) Compound having polyalkylene glycol structure | EXCENOL3020 | | | | | | |
| | EXCENOL2020 | | | | | | |
| | EXCENOL5030 | | | | | | |
| | PP-4000 | | | | | | |
| | GP-4000V | | | | | | |
| | polyethylene glycol 4000 | | | | | | |
| | polypropyleneglycol, triol type, Mw1500 | | | | | | |
| | NEWPOL 50HB-5100 | | | | | | |
| | EPAN | | | | | | |
| | TEGO WET270 | 5.0 | | | | | |
| | MEGAFACE F563 | | 5.0 | | | | |
| | SURFLON S-243 | | | 5.0 | | | |
| | BYK 3500 | | | | 5.0 | | |
| | BYK 377 | | | | | 5.0 | |
| | BYK 3510 | | | | | | 5.0 |
| Comparison (d) | GP-1000 | | | | | | |
| | triethylene glycol | | | | | | |
| | IPA | | | | | | |
| Initiator | Omnirad TPO | 1.5 | 1.5 | 1.5 | 1.5 | 1.5 | 1.5 |
| Pigment dispersion | Cyan particle dispersion (A) | 0.1 | 0.1 | 0.1 | 0.1 | 0.1 | 0.1 |
| Total (parts by weight) | | 106.6 | 106.6 | 106.6 | 106.6 | 106.6 | 106.6 |
| Evaluation results | Warpage in a film thickness of 400 µm | ++ | ++ | ++ | ++ | ++ | ++ |
| | Warpage in a film thickness of 300 µm | ++ | ++ | ++ | ++ | ++ | ++ |
| | Warpage in a film thickness of 200 µm | ++ | ++ | ++ | ++ | ++ | ++ |
| | Warpage in a film thickness of 100 µm | ++ | ++ | ++ | ++ | ++ | ++ |
| | Curring depth | ++ | ++ | ++ | ++ | ++ | ++ |

**Table 7**

| | Product name | Comparative Example | | | | | |
|---|---|---|---|---|---|---|---|
| | | 1 | 2 | 3 | 4 | 5 | 6 |
| (a) Monofunctional acrylic monomer | isobornylacrylate | 17.5 | 17.5 | 17.5 | 17.5 | 17.5 | 17.5 |
| | tetrahydrofurfuryl acrylate | | | | | | |
| | phenoxyethylacrylate | | | | | | |
| | lauryl acrylate | | | | | | |
| (b) Polyfunctional acrylic monomer | EO-modified bisphenol A diacrylate | 65.0 | 65.0 | 65.0 | 65.0 | 65.0 | 65.0 |
| | trimethylolpropaneethoxy triacrylate | | | | | | |
| | tricyclodecanedimethanol diacrylate | | | | | | |
| (c) Polyfunctional acrylic oligomer | EBECRYL600 | 17.5 | 17.5 | 17.5 | 17.5 | 17.5 | 17.5 |
| | EBECRYL230 | | | | | | |
| | EBECRYL270 | | | | | | |
| | EBECRYL8402 | | | | | | |
| (d) Compound having polyalkylene glycol structure | EXCENOL3020 | | 1.0 | 3.0 | | | |
| | EXCENOL2020 | | | | | | |
| | EXCENOL5030 | | | | | | |
| | PP-4000 | | | | | | |
| | GP-4000V | | | | | | |
| | polyethylene glycol 4000 | | | | | | |
| | polypropyleneglycol, triol type, Mw1500 | | | | | | |
| | NEWPOL 50HB-5100 | | | | | | |
| | EPAN | | | | | | |
| | TEGO WET270 | | | | | | |
| | MEGAFACE F563 | | | | | | |
| | SURFLON S-243 | | | | | | |
| | BYK 3500 | | | | | | |
| | BYK 377 | | | | | | |
| | BYK 3510 | | | | | | |
| Comparison (d) | GP-1000 | | | | 5.0 | | |
| | triethylene glycol | | | | | 5.0 | |
| | IPA | | | | | | 5.0 |
| Initiator | Omnirad TPO | 1.5 | 1.5 | 1.5 | 1.5 | 1.5 | 1.5 |
| Pigment dispersion | Cyan particle dispersion (A) | 0.1 | 0.1 | 0.1 | 0.1 | 0.1 | 0.1 |
| Total (parts by weight) | | 101.6 | 102.6 | 104.6 | 106.6 | 106.6 | 106.6 |
| Evaluation results | Warpage in a film thickness of 400 µm | - | - | - | - | - | - |
| | Warpage in a film thickness of 300 µm | - | - | - | - | - | - |
| | Warpage in a film thickness of 200 µm | - | + | ++ | - | - | - |
| | Warpage in a film thickness of 100 µm | ++ | ++ | ++ | + | + | + |
| | Curring depth | ++ | ++ | ++ | ++ | ++ | + |

**Table 8**

| | Product name | Manufacturer name | Note |
|---|---|---|---|
| (a) Monofunctional acrylic monomer | isobornylacrylate | Osaka Organic Industry Ltd. | |
| | tetrahydrofurfuryl acrylate | Osaka Organic Industry Ltd. | |
| | phenoxyethylacrylate | Osaka Organic Industry Ltd. | |
| | lauryl acrylate | Osaka Organic Industry Ltd. | |
| (b) Polyfunctional acrylic monomer | EO-modified bisphenol A diacrylate | Daicel-Allnex Ltd. | |
| | trinethylolpropaneethoxy triacrylate | Daicel-Allnex Ltd. | |
| | tricyclodecanedimethanol diacrylate | Daicel-Allnex Ltd. | |
| (c) Polyfunctional acrylic oligomer | EBECRYL600 | Daicel-Allnex Ltd. | epoxy acrylate |
| | EBECRYL230 | Daicel-Allnex Ltd. | urethane acrylate |
| | EBECRYL270 | Daicel-Allnex Ltd. | urethane acrylate |
| | EBECRYL8402 | Daicel-Allnex Ltd. | urethane acrylate |

**Table 9**

| | Product name | Manufacturer name | Note |
|---|---|---|---|
| (d) Compound having polyalkylene glycol structure | <Polyalkylene glycol> | | |
| | EXCENOL3020 | AGC Inc. | Mw: 3200, polypropylene glycol |
| | EXCENOL2020 | AGC Inc. | Mw: 2000, polypropylene glycol |
| | EXCENOL5030 | AGC Inc. | Mw: 5100, polypropylene glycol |
| | PP-4000 | Sanyo Chemical Industries, Ltd. | Mw: 4000, polypropylene glycol |
| | GP-4000V | Sanyo Chemical Industries, Ltd. | Mw: 4000, polypropylene glycol |
| | polypropyleneglycol, triol type, Mw1500 | FUJIFILM Wako Pure Chemical Corporation | Mw: 1500, polypropylene glycol, triol type |
| | polyethylene glycol 4000 | FUJIFILM Wako Pure Chemical Corporation | Mw: 4000, polyethylene glycol |
| | <Surfactant having polyalkylene glycol structure> | | |
| | NEWPOL 50HB-5100 | Sanyo Chemical Industries, Ltd. | Mw: 3750, water-soluble polyoxyethylene polyoxypropylene glycol monoalkylether |
| | EPAN | DKS Co., Ltd. | polyoxyethylene polyoxypropylene glycol |
| | TEGO WET270 | Evonik Industries AG | polyethersiloxane copolymer |
| | MEGAFACEF563 | DIC Corporation | fluorine-based surfactant |
| | SURFLON S-243 | AGC Seimi Chemical Co., Ltd. | fluorine-based surfactant |
| | BYK 3500 | BYK-Chemie GmbH | polyether-modified polydimethyls ilomne |
| | BYK 377 | BYK-Chemie GmbH | hydroxyl group-containing polyether-modified polydimethyls ilomne |
| | BYK 3510 | BYK-Chemie GmbH | polyether-modified polydimethylsilomne |
| Comparison (d) | GP-1000 | Sanyo Chemical Industries, Ltd. | Mw: 1000, polypropylene glycol |
| | triethylene glycol | Tokyo Chemical Industry Co., Ltd. | |
| | is opropyl alcohol (IPA) | Sankyo Kagaku Yakuhin Co., Ltd. | |
| Initiator | Omnirad TPO | IGM Resins B.V. | 2,4,6-trimethylbenzoyl diphenylphosphine oxide |

Aspects of the present invention include the following items.

According to Aspect 1, a curable composition contains:
a monofunctional acrylic monomer;
a polyfunctional acrylic monomer;
a polyfunctional acrylic-based oligomer; and
a compound having a polyalkylene glycol structure;
wherein the polyfunctional acrylic-based oligomer is at least one of a polyfunctional aliphatic urethane acrylate, a polyfunctional polyester acrylate, and a polyfunctional epoxy acrylate,
wherein the compound having a polyalkylene glycol structure has a molecular weight of 1,500 or more, and
wherein a content of the compound having a polyalkylene glycol structure is 5 parts by mass or more to 15 parts by mass or less relative to 100 parts by mass of the total of the monofunctional acrylic monomer, the polyfunctional acrylic monomer, and the polyfunctional acrylic-based oligomer.

According to Aspect 2, in the curable composition of Aspect 1, the compound having a polyalkylene glycol structure contains at least one of polyalkylene glycol and a surfactant having a polyalkylene glycol structure.

According to Aspect 3, in the curable composition of Aspect 2, the compound having a polyalkylene glycol structure contains the polyalkylene glycol and the surfactant having a polyalkylene glycol structure.

According to Aspect 4, in the curable composition of any of Aspects 2 and 3, the surfactant having a polyalkylene glycol structure comprises at least one of a non-ionic surfactant, a fluorine-based surfactant, and a silicone-based surfactant.

According to Aspect 5, a cured product is produced by curing the curable composition of any of Aspects 1 to 4.

According to Aspect 6, a method of producing a cured product includes:
supplying the curable composition of any of Aspects 1 to 4 onto a stage or beneath a stage; and
curing at least a part of the curable composition thus supplied by emitting, thereto, light with a wavelength of 350 nm to 420 nm.

According to Aspect 7, an apparatus for producing a cured product includes:
a storage container storing the curable composition of any of Aspects 1 to 4;
a supplying unit to supply the curable composition onto a stage or beneath a stage; and
a curing unit to cure at least a part of the curable composition thus supplied by emitting, thereto, light with a wavelength of 350 nm to 420 nm.

The curable composition of any of Aspects 1 to 4, the cured product of Aspect 5, the method of producing a cured product of Aspect 6, and the apparatus for producing a cured product of Aspect 7 can solve the aforementioned conventional problems and achieve the aforementioned objective of the present embodiment.

Any one of the above-described operations may be performed in various other ways, for example, in an order different from the one described above.

## Claims

1. A curable composition comprising:
a monofunctional acrylic monomer;
a polyfunctional acrylic monomer;
a polyfunctional acrylic-based oligomer; and
a compound having a polyalkylene glycol structure,
wherein the polyfunctional acrylic-based oligomer is at least one of a polyfunctional aliphatic urethane acrylate, a polyfunctional polyester acrylate, and a polyfunctional epoxy acrylate,
wherein the compound having a polyalkylene glycol structure has a molecular weight of 1,500 or more, and
wherein a content of the compound having a polyalkylene glycol structure is 5 parts by mass or more to 15 parts by mass or less relative to 100 parts by mass of the total of the monofunctional acrylic monomer, the polyfunctional acrylic monomer, and the polyfunctional acrylic-based oligomer.

2. The curable composition according to claim 1, wherein the compound having a polyalkylene glycol structure comprises at least one of polyalkylene glycol and a surfactant having a polyalkylene glycol structure.

3. The curable composition according to claim 2, wherein the compound having a polyalkylene glycol structure comprises the polyalkylene glycol and the surfactant having a polyalkylene glycol structure.

4. The curable composition according to claim 2 or 3, wherein the surfactant having a polyalkylene glycol structure comprises at least one of a non-ionic surfactant, a fluorine-based surfactant, and a silicone-based surfactant.

5. A cured product produced by curing the curable composition according to any one of claims 1 to 4.

6. A method of producing a cured product, the method comprising:
supplying the curable composition according to any of claims 1 to 4 onto a stage (10) or beneath a stage (10); and
curing at least a part of the curable composition thus supplied by emitting, thereto, light (30) with a wavelength of 350 nm to 420 nm.

7. An apparatus for producing a cured product, the apparatus comprising:
a storage container storing the curable composition according to any of claims 1 to 4;
a supplying unit to supply the curable composition onto a stage or beneath a stage (10); and
a curing unit to cure at least a part of the curable composition thus supplied by emitting, thereto, light (30) with a wavelength of 350 nm to 420 nm.

## Patentansprüche

1. Härtbare Zusammensetzung, umfassend:
ein monofunktionelles Acrylmonomer;
ein polyfunktionelles Acrylmonomer;
ein polyfunktionelles Oligomer auf Acrylbasis; und
eine Verbindung mit einer Polyalkylenglykolstruktur,
wobei das polyfunktionelle Oligomer auf Acrylbasis mindestens eines ist von einem polyfunktionellen aliphatischen Urethanacrylat, einem polyfunktionellen Polyesteracrylat oder einem polyfunktionellen Epoxidacrylat,
wobei die Verbindung mit einer Polyalkylenglykolstruktur ein Molekulargewicht von 1.500 oder mehr aufweist und
wobei ein Gehalt der Verbindung mit einer Polyalkylenglykolstruktur bezogen auf 100 Masseteile der Gesamtmenge des monofunktionellen Acrylmonomers, des polyfunktionellen Acrylmonomers und des polyfunktionellen Oligomers auf Acrylbasis 5 Masseteile oder mehr bis 15 Masseteile oder weniger beträgt.

2. Härtbare Zusammensetzung nach Anspruch 1, wobei die Verbindung mit einer Polyalkylenglykolstruktur mindestens eines umfasst von Polyalkylenglykol und einem Tensid mit einer Polyalkylenglykolstruktur.

3. Härtbare Zusammensetzung nach Anspruch 2, wobei die Verbindung mit einer Polyalkylenglykolstruktur das Polyalkylenglykol und das Tensid mit einer Polyalkylenglykolstruktur umfasst.

4. Härtbare Zusammensetzung nach Anspruch 2 oder 3, wobei das Tensid mit einer Polyalkylenglykolstruktur mindestens eines umfasst von einem nichtionischen Tensid, einem Tensid auf Fluorbasis oder einem Tensid auf Silikonbasis.

5. Gehärtetes Produkt, das durch Härten der härtbaren Zusammensetzung nach einem der Ansprüche 1 bis 4 produziert wurde.

6. Verfahren zum Produzieren eines gehärteten Produkts, wobei das Verfahren Folgendes umfasst:
Zuführen der härtbaren Zusammensetzung nach einem der Ansprüche 1 bis 4 auf eine Plattform (10) oder unterhalb einer Plattform (10); und
Härten mindestens eines Teils der so zugeführten härtbaren Zusammensetzung durch Emittieren von Licht (30) mit einer Wellenlänge von 350 nm bis 420 nm daran.

7. Einrichtung zum Produzieren eines gehärteten Produkts, wobei die Einrichtung Folgendes umfasst:
einen Lagerungsbehälter, der die härtbare Zusammensetzung nach einem der Ansprüche 1 bis 4 lagert;
eine Zuführungseinheit zum Zuführen der härtbaren Zusammensetzung auf eine Plattform oder unterhalb einer Plattform (10); und
eine Härtungseinheit zum Härten mindestens eines Teils der so zugeführten härtbaren Zusammensetzung durch Emittieren von Licht (30) mit einer Wellenlänge von 350 nm bis 420 nm daran.

## Revendications

1. Composition durcissable comprenant :
un monomère acrylique monofonctionnel ;
un monomère acrylique polyfonctionnel ;
un oligomère polyfonctionnel à base d'acrylique ; et
un composé présentant une structure de polyalkylène glycol,
dans lequel l'oligomère polyfonctionnel à base d'acrylique est au moins l'un des suivants : un acrylate d'uréthane aliphatique polyfonctionnel, un acrylate de polyester polyfonctionnel et un acrylate époxy polyfonctionnel,
dans lequel le composé présentant une structure de polyalkylène glycol présente un poids moléculaire de 1 500 ou plus, et
dans lequel la teneur en composé présentant une structure de polyalkylène glycol est de 5 parties en masse ou plus à 15 parties en masse ou moins par rapport à 100 parties en masse du total du monomère acrylique monofonctionnel, du monomère acrylique polyfonctionnel et de l'oligomère à base d'acrylique polyfonctionnel.

2. Composition durcissable selon la revendication 1, dans laquelle le composé présentant une structure de polyalkylène glycol comprend au moins un polyalkylène glycol et un tensioactif présentant une structure de polyalkylène glycol.

3. Composition durcissable selon la revendication 2, dans laquelle le composé présentant une structure de polyalkylène glycol comprend le polyalkylène glycol et le tensioactif présentant une structure de polyalkylène glycol.

4. Composition durcissable selon la revendication 2 ou 3, dans laquelle le tensioactif présentant une structure de polyalkylène glycol comprend au moins un tensioactif non ionique, un tensioactif à base de fluor et un tensioactif à base de silicone.

5. Produit durci obtenu par durcissement de la composition durcissable selon l'une quelconque des revendications 1 à 4.

6. Procédé de production d'un produit durci, le procédé comprenant :
l'introduction de la composition durcissable selon l'une quelconque des revendications 1 à 4 sur une plateforme (10) ou sous une plateforme (10) ; et
le durcissement d'au moins une partie de la composition durcissable ainsi fournie en émettant, sur celle-ci, de la lumière (30) avec une longueur d'onde de 350 nm à 420 nm.

7. Appareil de production d'un produit durci, l'appareil comprenant :
un récipient de stockage contenant la composition liquide durcissable selon l'une quelconque des revendications 1 à 4 ;
une unité d'alimentation pour déposer la composition durcissable sur une plateforme ou sous une plateforme (10) ; et
une unité de durcissement pour durcir au moins une partie de la composition durcissable ainsi fournie en émettant, sur celle-ci, de la lumière (30) avec une longueur d'onde de 350 nm à 420 nm.
